# EUROPEAN PATENT SPECIFICATION

(11) **EP 1 937 047 B1**
(45) Date of publication and mention of the grant of the patent: **03.08.2011**
(21) Application number: 06026855.4
(22) Date of filing: 23.12.2006
(51) Int. Cl.: H05K 7/20, H01L 23/427

(54) **Flexible heat cable device**
Flexible Heizkabelvorrichtung
Dispositif de câble chauffant flexible

(43) Date of publication of application: 25.06.2008
(73) Proprietor: ABB RESEARCH LTD., 8050 Zürich (CH)
(72) Inventor: Yesin, Berk, 8038 Zürich (CH); Jylhakallio, Mervi, 02230 Espoo (FI); Kauhanen, Matti, 02660 Espoo (FI); Balta, Jose, 1022 Chavannes p. Renens (CH)
(74) Representative: ABB Patent Attorneys

(56) References cited:
- US-A- 6 084 769
- US-A1- 2002 105 784
- US-A1- 2003 019 607
- US-A1- 2005 219 820
- US-A1- 2006 162 903
- US-B1- 6 209 626

## Description

The present invention relates to a cooling apparatus, especially for cooling an electronic device, and to a cooling method. Embodiments include a flexible heat transfer device for cooling electronic devices to be cooled using a heat sink which is located remotely from the electronic device to be cooled. In particular, the present invention relates to thermosyphon, in which two-phase heat transfer means are enclosed.

A major advantage of a flexible heat transfer device which can be made from a flexible material is to define a flexible thermal path between electronic devices to be cooled and heat sinks. Such a mechanical flexibility allows easy routing and attaching of the heat cable in different geometric configurations of an electronic circuit.

### BACKGROUND

A flexible thermosyphon device is described in Electronics Cooling Magazine, February 2006 (http://www.electronics- cooling.com/html/2006 led a3.html). The disclosed thermosyphon device consists of a boiler, a cap, a tube and a 100 mm x 100 mm condenser. The device allows a flexible arrangement between a heat source (i.e. an electronic component to be cooled) and a heat sink.

Another conventional flexible heat pipe is disclosed in "http://sbir.gsfc.nasa.gov/sbir/successes/ss/100text.html". The disclosed flexible heat pipe consists of a modular clamp-on plate, a flexible heat pipe code plate and a thermal bus receptacle. The heat pipe provides a mechanical support and a transfer of waste heat from a space station equipment to a thermal bus.

In the US patent US 5,642,776, a heat pipe in the form of a simple foil envelope and a method of construction such a heat pipe are disclosed. Two metal foil sheets coated with a plastic material are sealed together on all four edges to enclose a semi-rigid sheet of plastic film, and the envelope is evacuated and loaded with a suitable quantity of liquid to act as a heat pipe.

The device disclosed in US 5,642,776 operates as a heat spreader for an integrated circuit chip placed in contact with the envelope surface. The heat is transferred across the plastic coating with only a small temperature differential. A foam plastic wick with channels efficiently transports condensed liquid back to the heat input location for evaporation. Some liquid, in particular that transported to the surface of the foam wick, is vaporized by the applied heat, and that liquid is continuously replaced by the capillary action of the wick and the channels. A disadvantage of the envelope heat pipe device disclosed in US 5,642,776 is that the materials in the heat pipe are bad conductors of heat such that the heat conductivity is decreased.

In US 4,565,243, a heat pipe is disclosed, which is constructed to be bent to conform to a particular mechanical configuration after it is constructed. A wick in the evaporator region is constructed from sintered metal powder, while the wick in another region of the heat pipe is constructed with a screen wick to permit bending the pipe without destruction of the wick.

The disclosed heat pipe comprises a completely enclosed casing of sufficiently thin and ductile material to permit bending of the casing at least once without rupture of the casing. Furthermore, the heat pipe comprises first and second wick structures, wherein the second wick structure consists of at least two separate screen layers. The outer screen layer is sintered to the inside surface of the casing and the other layer is located in intimate contact with the outer layer. An appropriate heat transfer fluid is provided in the heat pipe.

The US patent US 4,345,642 discloses an articulated heat pipe wherein a multiple section heat pipe has flexible junctions between the sections. The individual sections are independent individual heat pipes configured to interlock with each other at rotatable joints filled with a liquid having a high heat conductivity. A clearance between the sections is maintained small enough to establish capillary forces that maintain the conductive liquid in place and also to minimize the temperature differential across the rotating joint.

The thermal operation of the system depends only upon conventional operation of the heat pipes, such that a condensing section of heat pipe is located on one side of the rotating junction, while the evaporating region of the other heat pipe is in contact with the other side of the junction. A thin layer of conducting fluid spread over the relatively large surface area of the cylindrical geometry of the fluid gap maintains a minimal temperature difference between the co-acting regions of the two heat pipes.

The US 4,961,463 discloses a thermosyphon for removing heat from a permafrost foundation. The device can be installed in a frozen foundation with an evaporator section disposed either horizontally or with a negative slope, thereby allowing the evaporator section of the thermosyphon to be buried in a more shallow location of the foundation. The device comprises a condensate collecting ring device wherein condensate flows downwardly along a inner wall surface of a condenser section and collects in an inner ring. The ring slopes downwardly from the horizontal such that a condensate is collected a low point thereof. A condensate return tube communicates with the collector ring at the low point thereof and ducts the condensate into the evaporator section to a desired location within the evaporator section. The condenser return tube has a length which acts to deposit the condensate at the desired location within the evaporator section.

Another coding system is known from US 2003/019607, which shows the features of the preamble of claim 1.

A major disadvantage of conventional cooling systems is that electronic components to be cooled cannot be replaced in an easy and efficient manner.

### SUMMARY OF THE INVENTION

It is an object of the present invention to reduce at least some of the above-mentioned problems and / or to provide an effective cooling means with a high flexibility.

This object is achieved by a cooling apparatus for cooling electronic devices according to the independent apparatus claim 1. Furthermore, the object is achieved by a method comprising the steps of the independent method claim. Further refinements of the invention follow from the dependent claims.

According to an aspect of the invention, an open-ended heat transfer mechanism is provided, which is only completed with an external cooling interface similar to an electrical instrument which is delivered to a customer with a power plug.

Various condenser-side interfaces may be provided. Thus the essential concept of the present invention is to provide a flexible heat cable device which is capable of acting as a thermal equivalent of electrical cables and which has an increased flexibility in an overall mechanical design of power electronics systems.

According to an aspect of the present invention a cooling apparatus for cooling an electronic device to be cooled comprises a heat collector device which is in thermal contact with the electronic device, a heat sink for absorbing heat which is emitted from the heat collector device and comprising a condenser unit and a thermal interface unit, wherein the condenser unit is cooled down via the thermal interface unit, and a heat transfer device made from a flexible material for transferring heat which is emitted from the heat collector device to the heat sink.

It is an advantage of the present invention that the thermal interface unit is designed as a thermal plug for connecting the condenser unit of the heat sink thermally and removably to an external cooling means.

According to a further aspect, a method for cooling an electronic device to be cooled comprises the following steps: (i) collecting heat from the electronic device to be cooled by a heat collector device which is in thermal contact with the electronic device to be cooled; (ii) transferring heat which is emitted from the heat collector device to the heat sink by means of a heat transfer device made from a flexible material; and (iii) absorbing heat which is emitted from the heat collector device by means of a heat sink comprising a condenser unit and a thermal interface unit, wherein the condenser unit is cooled down via the thermal interface unit, The thermal interface unit is designed as a thermal plug for connecting the condenser unit of the heat sink thermally and removably to an external cooling means and an external cooling bus, respectively.

The dependent claims contain advantageous developments and improvements of the respective subject matter of the invention.

In line with one preferred development of the present invention, the heat transfer device includes an electrical connection unit to simultaneously transfer thermal and electrical energy between the electronic device and the heat sink.

In line with a further preferred development of the present invention, the electronic device is soldered to the heat collector device.

In line with yet another preferred development of the present invention, the heat transfer device is made of a thermoplastic polymer.

In line with yet another preferred development of the present invention, the heat transfer device is made of at least one of polyethylene, polyethylene-terephthalate and polystyrene.

In line with yet another preferred development of the present invention, the heat transfer device includes a metal layer deposited on the outer surface of the heat transfer device.

In line with yet another preferred development of the present invention, the heat transfer device is made of super-elastic alloys.

In line with yet another preferred development of the present invention, the condenser unit comprises a pump unit for pumping back liquid, which has been collected in a condensate collector.

In line with yet another preferred development of the present invention, the pump unit of the condenser unit is driven by the flow of cooling water.

In line with yet another preferred development of the present invention, the heat sink and the heat transfer device form a thermosyphon device.

In line with yet another preferred development of the present invention, the heat sink is cooled by a secondary circulation of cooling water.

In line with yet another preferred development of the present invention, the heat transfer device transfers heat from the heat collector device to the heat sink by transporting a liquid coolant from the heat collector device to the heat sink and by returning evaporated coolant from the heat sink to the heat collector device.

In line with yet another preferred development of the present invention, the condenser unit of the heat sink is directly cooled by the circulating cooling water.

The present invention in particular is related to cooling of power electronic systems and low voltage devices. In power electronic systems, a significant amount of heat can be generated within a small volume such that the generated heat must be dissipated to the environment.

Instead of attaching the heat generating components directly to a heat sink, an intermediate mechanism of heat transfer in the form of a heat-carrying cable is used to separate the source and the sink of thermal energy.

This kind of separation assists in the mechanical design of power electronic systems. In addition to that, the heat cable can also be used to adapt standard products to special customer requirements, for example, by interfacing a drive to the customer's own cooling system.

### DRAWINGS

Embodiments of the present invention are depicted in the drawings and are explained in more detail in the following description. In the drawings like or similar elements bear like reference numerals.

In the drawings:
- Fig. 1: is a principle block diagram for illustrating the function of a thermosyphon;
- Fig. 2: illustrates a flexible heat cable device arranged between power electronics module and a cooling system according to a preferred embodiment of the present invention;
- Fig. 3: illustrates a flexible heat cable device depicted in Fig. 2 and shown disassembled;
- Fig. 4(a): illustrates a heat collector device which is attached to the heat transfer device according to a preferred embodiment of the present invention;
- Fig. 4(b): shows a detail of the heat collector device depicted in Fig. 4(a);
- Fig. 5: illustrates a condenser unit as a part of a heat sink in a cross-sectional view;
- Fig. 6: illustrates details of liquid channels of the condenser unit shown in Fig. 5;
- Fig. 7: is a cross-sectional view of a condenser unit of another embodiment of the present invention showing a liquid return hose;
- Fig. 8: shows a condensate collector which is included in the condenser unit shown in Fig. 7;
- Fig. 9: is another detailed view of the condenser unit shown in Fig. 7;
- Fig. 10: illustrates a liquid-cooled cylindrical condenser unit with direct contact to cooling water;
- Fig. 11: is a cross-sectional view of the heat sink mounted to the flexible heat cable device shown in Fig. 10;
- Fig. 12: is a condenser unit according to yet another preferred embodiment of the present invention using a unit for pumping condensed liquid; and
- Fig. 13: shows details of a water-driven pump unit arranged in the heat sink of the flexible heat cable device shown in Fig. 11.

### DETAILED DESCRIPTION OF THE DRAWINGS

The present invention now will be described more fully hereinafter with reference to the accompanying drawings, in which preferred embodiments of the invention are shown.

Two-phase heat transfer systems utilize liquid-vapour phase exchange processes for increased heat transfer between a heat source and a working fluid, and between a heat sink and the working fluid, respectively. Two-phase heat transfer components are heat pipes and thermosyphons.

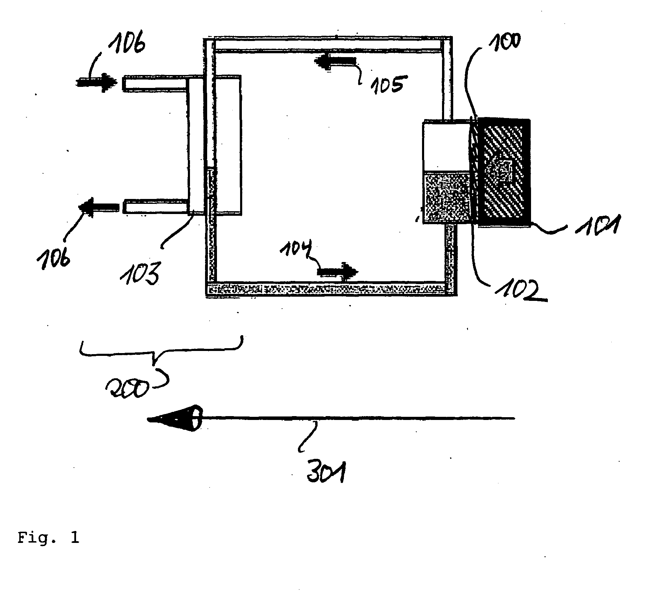

Fig. 1 shows a block diagram for explaining the operation of a thermosyphon. An electronic device 101 to be cooled is attached to an evaporator unit 102. It is noted that different electronic devices 101 may be connected to a series of evaporator units 102 which in turn are connected to a single condenser unit 103. An arrow 301 in Fig. 1 shows the heat transfer direction. The heat is transferred from the evaporator unit 102 to the condenser unit 103 which is cooled by cooling water 106.

A thermal contact between the evaporator unit 102 and the condenser unit 103 is established by a liquid-vapour circulation in which a liquid (cooling liquid) 104 is evaporated in the evaporator unit 102 by heat which is transferred to the evaporator unit 102 from the electronic device 101 to be cooled. The evaporated liquid (as vapour 105) is transferred back to the condenser unit 103 where it is condensed again into liquid 104.

The principle of exchanging liquid and vapour, respectively, between a heat source 101, 102 and a heat sink 103 is used for a flexible connection of electronic devices 101 to be cooled in a circuit, in particular in a power circuit, and to flexibly transfer heat to a remote heat sink 103, 200. Usually, the electronic device 101 to be cooled is attached to a heat collector device 100 which acts as an interface between the electronic device 101 to be cooled and the evaporator unit 102.

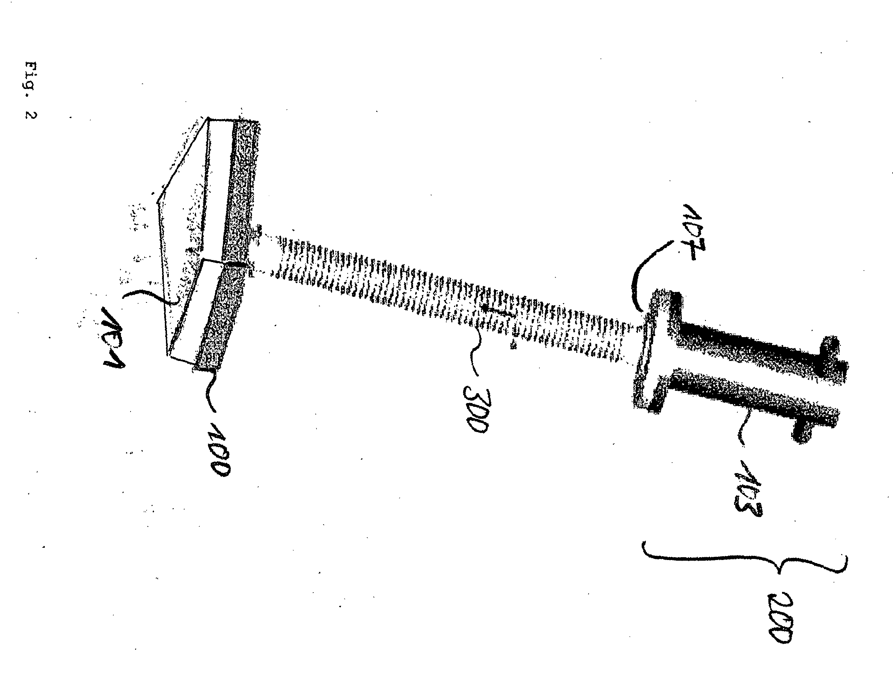

Fig. 2 illustrates the heat cable arranged between a power electronics module and a cooling system. Reference numeral 101 denotes the power electronics module, i.e. the electronic device to be cooled. It is noted that more than one electronic device can be connected to a respective heat sink 200 using a heat transfer device 300.

The flexible heat cable device shown in Fig. 2 is according to a first preferred embodiment of the present invention. The flexible heat cable device consists of a heat collector device 100 which is brought into thermo-contact with the electronic device 101 to be cooled. The heat transfer device 300 is used to transfer heat in the electronic device 101 to a heat sink 200 which essentially consists of a condenser unit 103. A connector unit 107 is provided to fix the heat transfer device 300 detachable at the condenser unit 103.

The flexible heat cable device is configured in a similar fashion to electrical cables, but it is used to transfer thermal energy instead of electrical energy. In a preferred deployment of the present invention, the flexible heat cable device comprises an electrical cable as an electric connection to simultaneously transfer thermal and electrical energy between the electronic device 101 and the heat sink 200. It is an advantage to construct the heat transfer device 300 from materials the high mechanical flexibility, thus permitting to route and attach the heat cable device in different geometrical configurations. The construction of the heat transfer device as a heat cable is discussed below.

An important application for the heat cable device is, besides cooling of electronic devices, cooling of high power electronic systems such as motor drives. To this end, the heat cable device can be used within the casing of a drive system to transfer heat between an IGBT module (IGBT, Insulated Gate Bipolar Transistor) and a water or air heat exchanger. The mechanical design of the whole system is facilitated due to the capability of the flexible heat cable device which allows routing of the cable within the casing and permits a separation of heat sources and heat exchangers. When a heat carrying cable is flexible, a suitably designed heat cable can be mass-manufactured and used in different devices.

The heat cable can also be routed out of the system casing and can be attached to an auxiliary heat exchanger, which can be shared by multiple systems. It is an advantage of the present invention, that different interfaces are provided to permit an adaptability of the heat cable device.

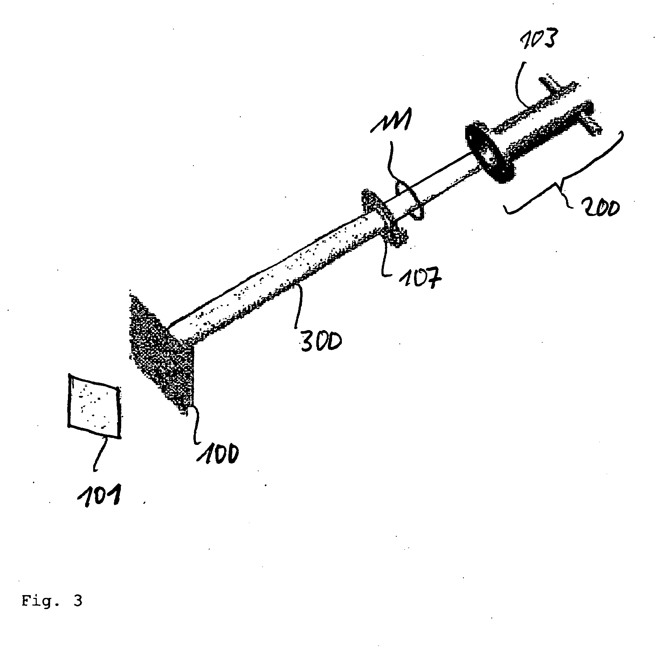

Fig. 3 shows the flexible heat cable device of Fig. 2 in an explosive view. A sealing unit designed as an O-Ring is provided to seal the heat sink 200 to the heat transfer device 300.

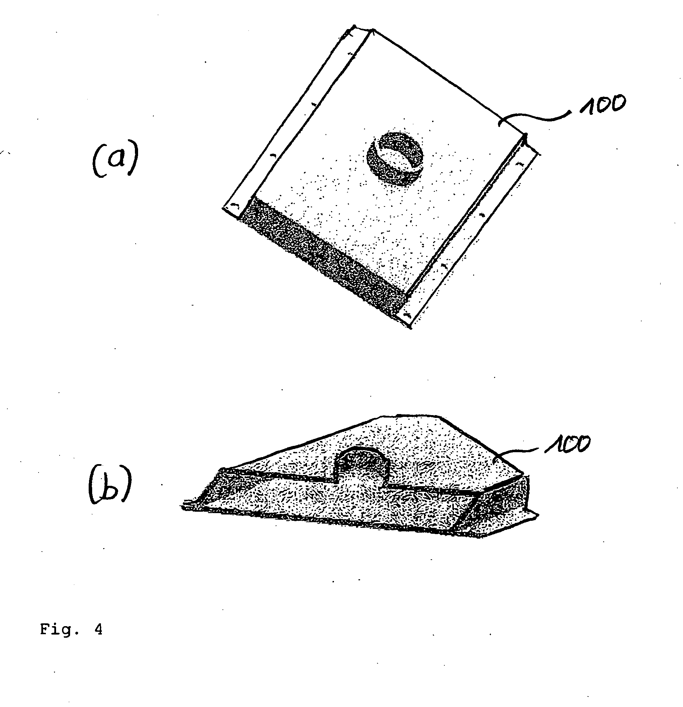

Figs. 4(a) and 4(b) illustrate the heat collector device 100 of the flexible heat cable device shown in Figs. 2 and 3. The heat collector device 100 can be designated as a "boiling" section. The boiling section is a chamber that is partly filled with the working fluid 104. Multiple components can be attached at the bottom and/or the side walls of this chamber. The chamber is preferably made of a material such as copper, brass, aluminum, etc., which has a high thermal conductivity. The selection of the material of the boiling section depends on the compatibility with the working fluid and on strength requirements.

As most electronic components, i.e. electronic devices 101, have a planar geometry with one side used for electrical interfacing and the other for thermal interfacing, the boiling section comprises one flat surface. In this case, a thermal base-plate of the component is used to spread the heat to a larger area and to add to a thermal capacitance for an improved temperature stability when a fluctuating heat dissipation is encountered.

According to another preferred embodiment of the present invention, the boiling section can also be integrated into this base-plate module. This means that the substrate of the power module can be directly soldered to this boiling section. Thus, the whole power module can be delivered by a semi-conductor manufacturer in one piece together with the boiling section, wherein an interface or opening to the heat transfer device 300 is provided.

In yet another preferred embodiment of the present invention, a bottom face of the boiling section can be opened such that a cavity which is able to receive liquid is only formed when the boiling section is attached to the module base-plate. The liquid is in direct contact with the module base-plate. O-Ring or gas-cap-type seals can be used at the periphery of the base-plate in order to provide a vacuum-tight sealing.

The heat transfer device 300 consists of a flexible conduit which is attached to the chamber to provide a gas-type conduit between the boiler and the condenser. There are different alternatives for the conduit construction. One possibility is to use a corrugated metal hose as shown in Figs. 2 and 3.

These kind of corrugated metal hoses are found in vacuum equipment. These hoses can withstand vacuum and high pressure at elevated temperatures. Most importantly, the solid metal hose is inherently gas-tight and is suitable for long term containment of a vacuum. This is a critical issue for power electronics equipment which have long term life-time expectancies.

In yet another preferred embodiment of the present invention, the conduit which form the heat transfer device 300 is made from a thermoplastic polymer. More preferably, the conduit is made from materials such as polyethylene, polyethylene-tereftalat, polyvinylchloride and polystyrene.

In yet another preferred embodiment of the present invention, the conduit which forms the heat transfer device 300, is deposited by one or more layers of metal. Preferably, aluminium is chosen as a suitable coating material because of costs and ease of fabrication. Furthermore, a multi-layer coating can be applied.

In addition to that the heat transfer device can be constructed from super-elastic alloys which have an enhanced intrinsic flexibility. Advantageously, the super-elastic alloys are metals and thus offer a leak-proof seal. Complete strain recovery is reached for up to 10% of deformation. A tube made of this material could be more readily deformed over closer angles than a metallic tube. Moreover, a shape-memory effect exhibited by these alloys can be utilized to correct the roughly bent shape of the conduit before operation of the cooling system.

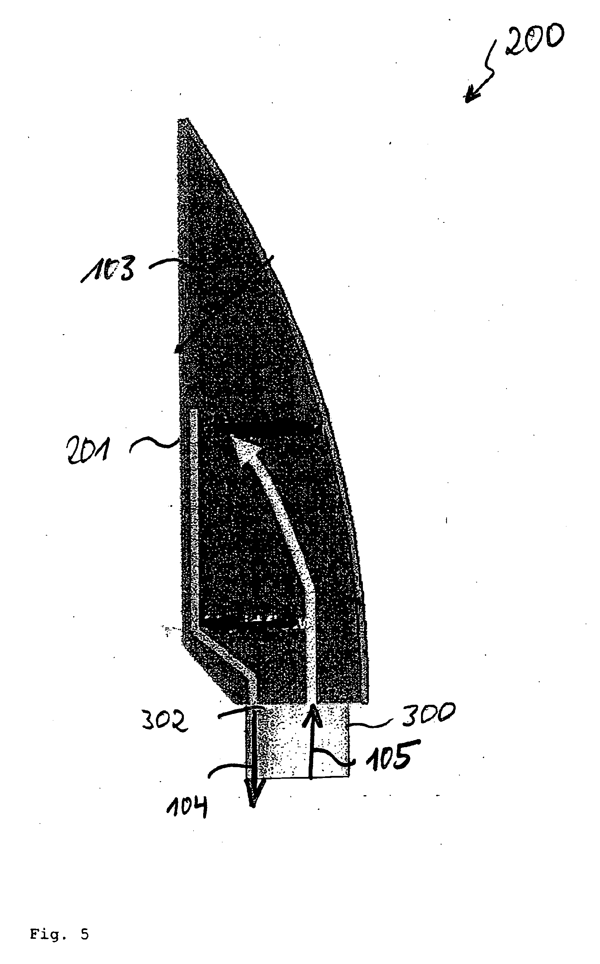

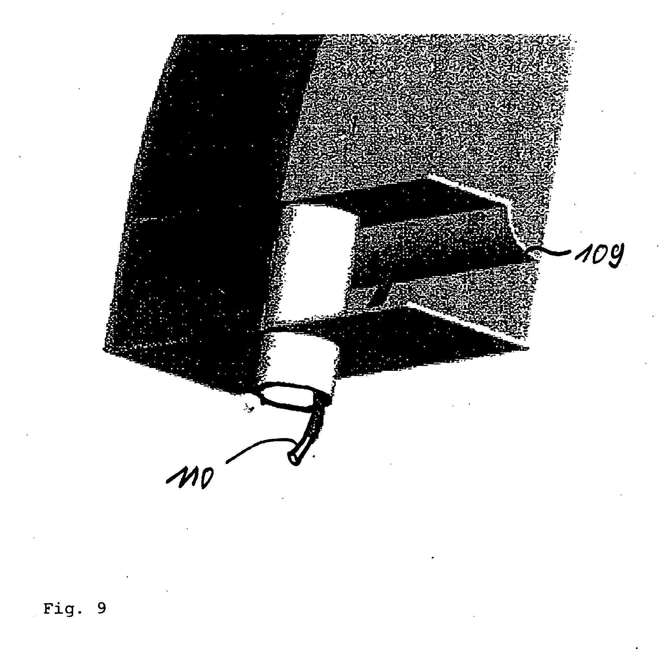

With reference to Figs. 5 to 9, the heat sink 200 of the flexible heat cable device will be described. The heat sink 200 essentially consists of a condenser unit 103, which has three main functions: (i) the condenser unit 103 provides a surface that is kept at a lower temperature than the saturation temperature of the vapour such that the vapour transferred through the heat transfer device 300 will contact this surface and will condensate; (ii) the condenser section provides a means by which the condensated liquid is able to flow backward into the boiling section of the heat collector device 100; and (iii) the condenser section acts as a thermal interface to an external cooling system with a minimal thermal resistance.

The condenser unit 103, which is shown in Fig. 5, is connected to the conduit, i.e. the heat transfer device 300. The outer side of the condenser unit 103 is attached to a cold-plate. Condensed liquid 104 flows, under the effect of gravity, to the bottom part of the condenser plate and then back to the boiling chamber through the conduit walls. Evaporated liquid is introduced as vapour 105 into the condenser unit 103.

Flow guides are provided to evenly distribute the liquid around the conduit entrance 302. A smooth surface or spirally configured corrugations of the conduit wall are to be preferred in order to minimize the liquid flow resistance.

In order to cool down the condenser unit 103, a cold plate (not shown in the figures) is attached to a thermal (cold plate) interface unit 201 of the condenser unit 103.

According to a preferred embodiment of the present invention the thermal interface unit 201 is designed as a thermal plug for connecting the condenser unit 103 of the heat sink 200 thermally and removably to an external cooling means. It is a major advantage of the present invention that an electronic device 101 can easily be connected and disconnected to external units with both electrical and thermal links.

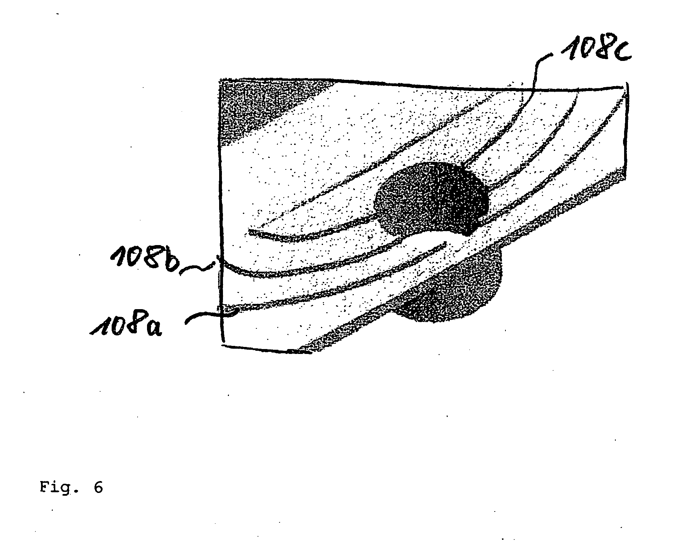

Fig. 6 exhibits details of the bottom part of the condenser unit 103. Shown in Fig. 6 are liquid channels 108a - 108c where condensed liquid is accumulated and transferred back to the heat collector device 100 (boiling section) via the walls of the heat transfer device 300.

In yet another preferred embodiment of the present invention, a secondary liquid conduit is provided. The secondary liquid conduit is arranged inside the primary conduit and can be of a smaller size, since the volumetric flow rate of the liquid is much smaller than the volumetric flow rate of the vapour. This secondary conduit is separated from the outside of the primary conduit, wherein special sealing properties have not to be provided. The main advantage of this design is that it avoids re-entrainment limitations due to the friction between the vapour and liquid in counter-flow.

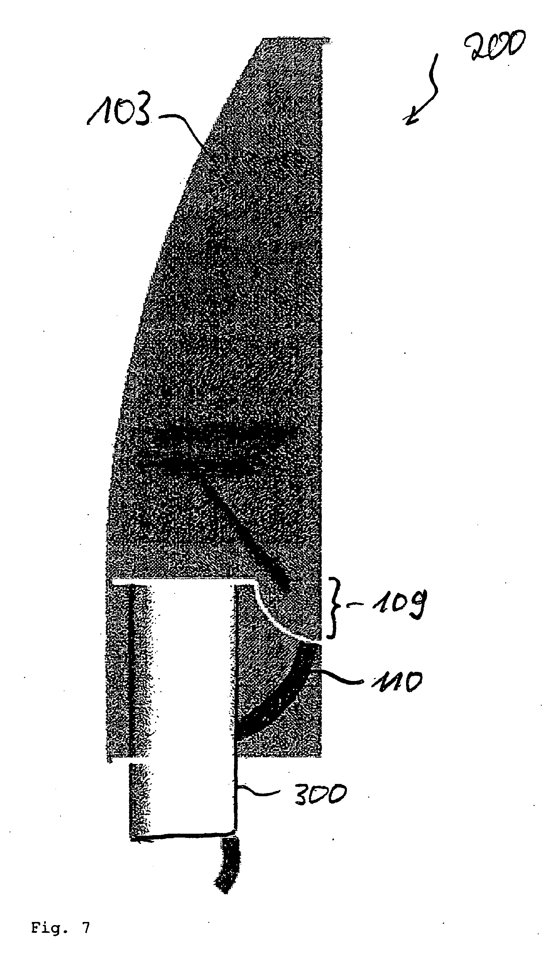

Fig. 7 illustrates a modification of the condenser unit 103 shown in Fig. 5. Here, a separate hose, i.e. a liquid return hose 110, is provided to return condensed liquid from the condenser unit 103 to the evaporator unit 102 of the heat collector device. Furthermore, a condensate collector 109 is provided to collect condensed vapour 105 and to guide it to the liquid return hose 110. Within the heat transfer device 300, the liquid return hose 110 is connected to the heat collector device 100 and the evaporator unit 102, respectively.

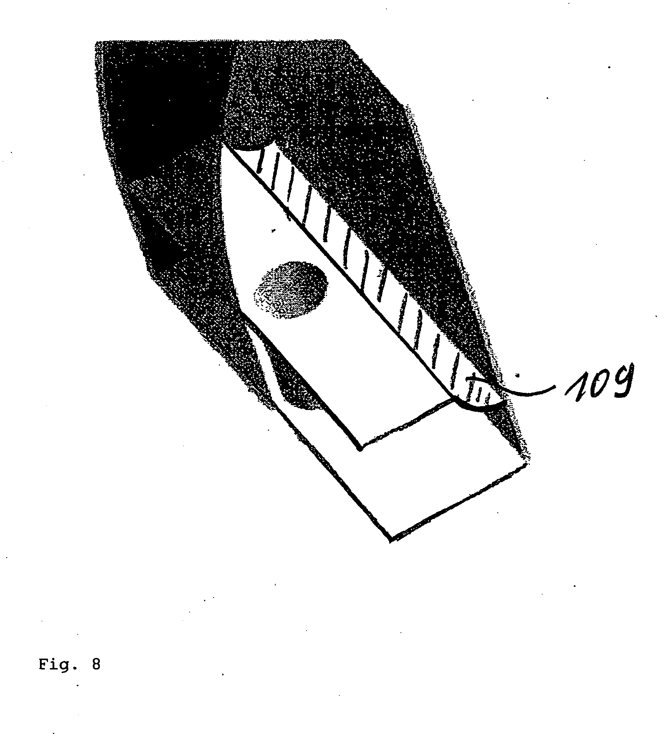

Fig. 8 exhibits details of the heat sink 200 depicted in Fig. 7. Especially, the construction of the condensate collector 109 is shown in greater detail.

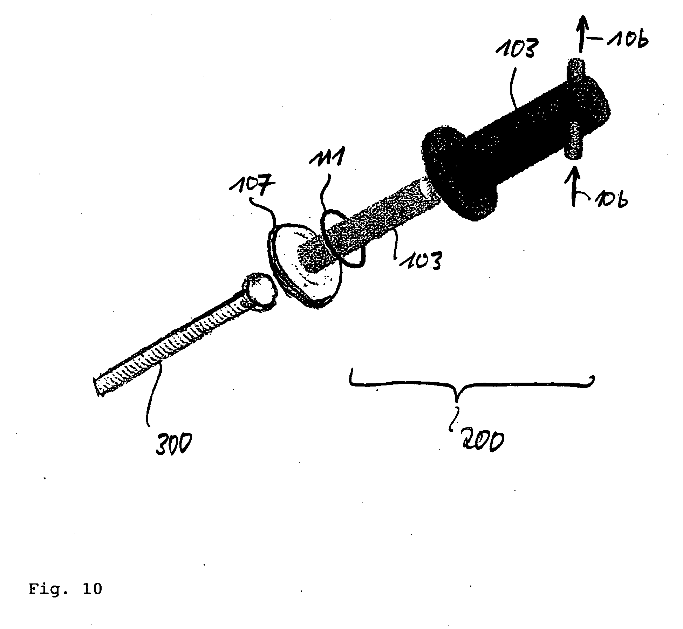

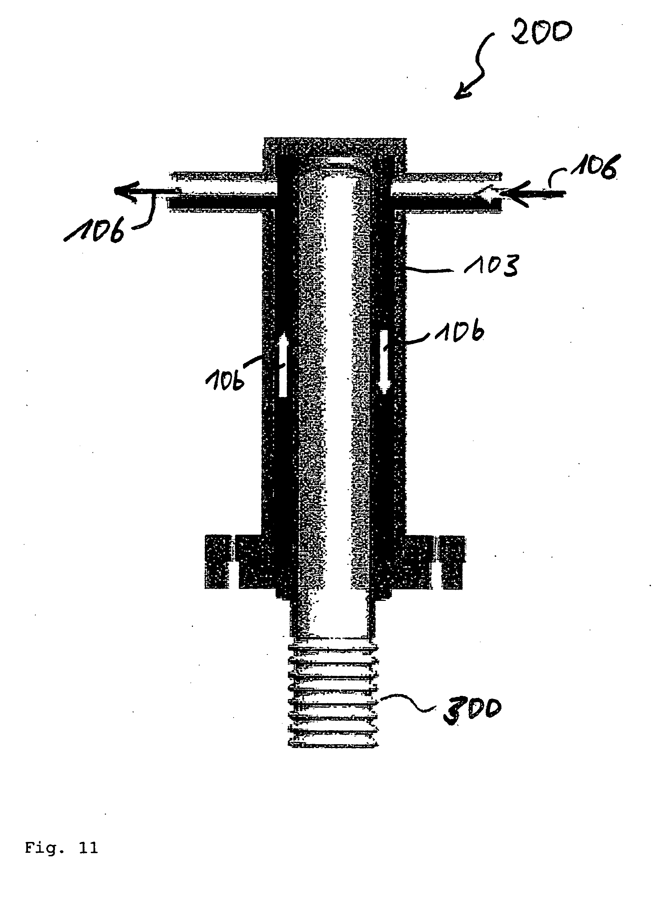

One disadvantage of the cold-plate design which is depicted in the previous figures, is that the thermal contact resistance (i.e. the thermal interface) between the condenser plate and the cold-plate is high. This resistance, having high values, is able to hamper the performance of the whole cooling apparatus. In order to overcome this drawback, Figs. 10 and 11 exhibit another concept for cooling the evaporator unit 102 of the heat sink 200.

As shown in Fig. 10, cooling water 106 flows into the head of the condenser unit 103 and exits the condenser unit at an opposite end. The cooling water 106 is not used to cool a cold-plate, but it cools the condenser unit 103 directly. Details of the flow path of the cooling water 106 are depicted in Fig. 11. A direct contact between the condenser unit 103 and the cooling water results in high heat transfer coefficients. The advantage of poviding the condenser section and the outside cold-channel as two separate parts is to minimize the dimensions of the heat cable which aids the routing of the cable. Alternatively, several heat cable condensers can be plugged into a multi-cable-cored shell.

It is to be noted, that, although Figs. 10 and 11 show a cylindrical configuration of the condenser unit 103, other units, i.e. rectangular forms or finned surfaces are also possible.

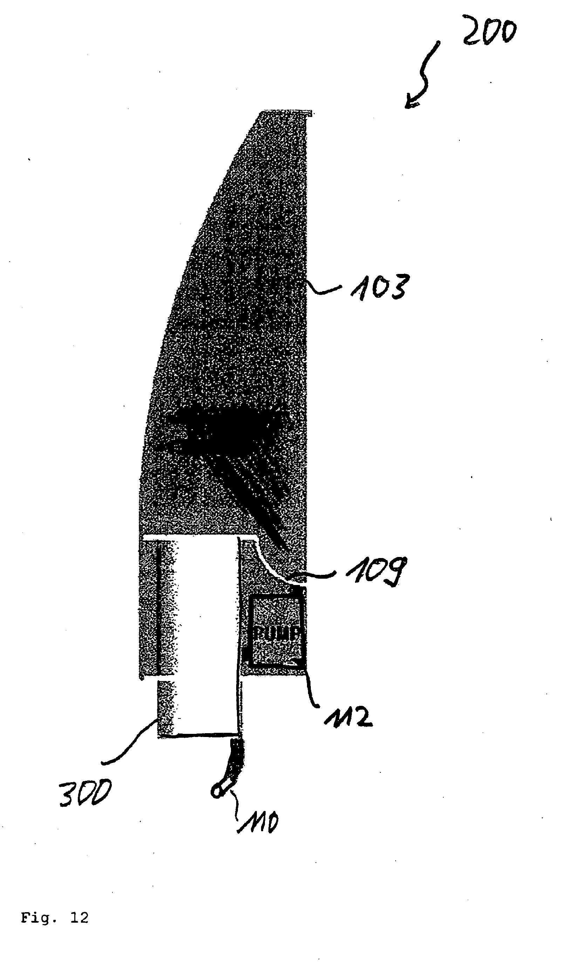

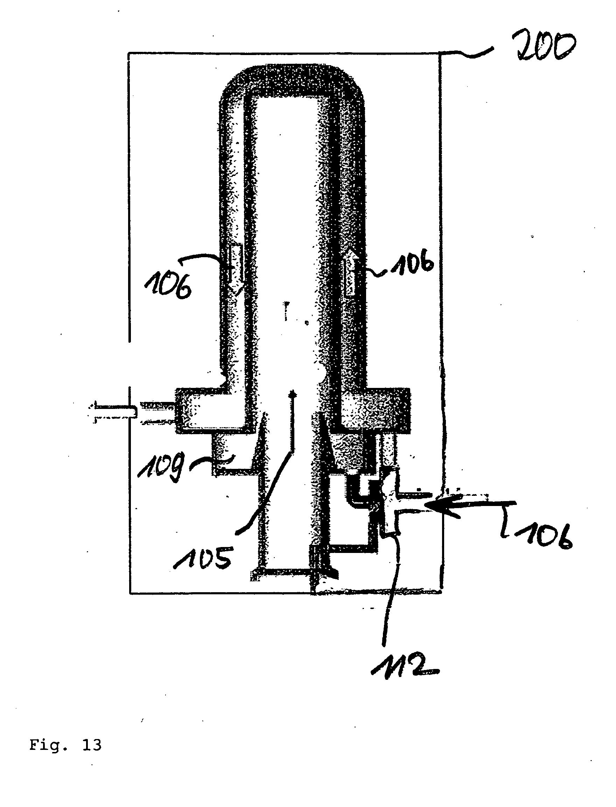

Figs. 12 and 13 show yet another preferred embodiment of the present invention. Wherein in the previous figures, the flow of the condensed liquid back to the evaporator unit 102 depends on gravity forces, the devices shown in Figs. 12 and 13 comprise a pump unit 112 in order to pump back liquid, which has been collected in the condensate collector 109. The liquid is pumped from the condensate collector 109 into the liquid return hose 110 by the pump unit 112.

If a liquid pump as a pump unit 112 is provided, the condenser unit 103 can be placed below the evaporator unit 102 of the heat collector device 100. One major advantage of a pumped two-phase system over a single-phase-(i.e. only liquid circulation)-system is that a much smaller amount of liquid needs to be pumped for the same amount of transferred energy. For example, in order to transfer 1000 W power with 10°C temperature difference at both ends approximately 1.5 1/min of liquid water have to be pumped. The amount of liquid that must be evaporated and condensed for the same power level is only 26 ml/min (at 1 atmosphere operation pressure). Consequently, the size and cost of the pump unit 112 in a two-phase system can be made smaller.

In order to provide a pump unit 112, diaphragm-type pumps are preferred. A diaphragm-type pump consists of a flexible membrane that is attached to an oscillating mechanism driven by an electric motor. Two one-way valves provide intermittent but unidirectional flow. The flow circuit is inherently sealed from outside by the membrane and no shaft seals are needed for the motor. In addition to that, diaphragm pumps can operate dry or with both liquid and gas mixtures.

According to yet another preferred embodiment of the present invention, an alternative to an electrically powered pump is utilized, which uses energy available in the external coolant liquid to pump the two-phase loop.

A turbine-pump combination (i.e. a hydraulically actuated pump) is inserted between the external coolant and the internal condensate circuits, as shown in Fig. 13. The mechanical energy provided by the cooling water 106 is extracted from the coolant at the pump unit 112, which is designed as a turbine, in order to pump the condensate. Thus a system is created that can operate against gravity forces. In both electrical and hydraulic pumped loops, the pumps are located within the condenser interface between a condenser collection chamber and the liquid return hose.

The embodiments of the present invention provide a cooling apparatus for electronic devices 101, to be cooled, wherein a flexible heat transfer device 300 can be used to transfer heat from within an electronic device 101 to be cooled to the outside without any openings.

It is an advantage that several electronic components can be grouped into a high IP-class casing with air circulation inside. The circulation can be facilitated either by a dedicated fan or by inherent cooling fans of the components. A flexible heat transfer device can then be used to transfer heat to the outside of the casing without interfering with the high IP-(Ingress Protection)-class of the whole electronic system.

The present invention provides a cooling apparatus, wherein a high heat and heat-density at the heat collector device is provided. An effective cooling means at the condenser-site, such as direct water-cooling or interfacing to a cold-plate, is provided.

It is a further advantage of embodiments of the present invention that unknown geometry of an application site at the time of manufacturing poses no problem. The exact geometry of the cooling means of an application and the setting of the drive need not to be known. The flexibility of the conduit with respect to general purpose interfaces can be provided.

The flexible heat cable device is an effective means to transfer heat to the outside of a casing without diminishing the ingress-protection-(IP)-class. This is especially important in industrial environments.

Furthermore, the invention is not limited to the specific application areas mentioned above.

### LIST OF REFERENCE NUMERALS

- 100: Heat collector device
- 101: Electronic device
- 102: Evaporator unit
- 103: Condenser unit
- 104: Liquid
- 105: Vapor
- 106: Cooling water
- 107: Connector unit
- 108a-108c: Liquid channel
- 109: Condensate collector
- 110: Liquid return hose
- 111: Sealing unit
- 112: Pump unit
- 200: Heat sink
- 201: Thermal interface unit
- 300: Heat transfer device
- 301: Heat transfer direction
- 302: Conduit entrance

## Claims

1. A cooling apparatus for cooling an electronic device (101) to be cooled, comprising:
a) a heat collector device (100) which is adapted to be in thermal contact with the electronic device (101);
b) a heat sink (200) for absorbing heat which is emitted from the heat collector device (100) and comprising a condenser unit (103) and a thermal interface unit (201), wherein the condenser unit (103) is cooled down via the thermal interface unit (201);
c) a heat transfer device (300) made from a flexible material for transferring heat which is emitted from the heat collector device (100) to the heat sink (200),
**characterized in that**
d) the thermal interface unit (201) is designed as a thermal plug for connecting the condenser unit (103) of the heat sink (200) thermally and removably to an external cooling means.

2. The cooling apparatus for cooling an electronic device (101) as claimed in claim 1, wherein the heat transfer device (300) includes an electrical connection unit to simultaneously transfer thermal and electrical energy between the electronic device (101) and the heat sink (200).

3. The cooling apparatus for cooling an electronic device (101) as claimed in claim 1, wherein the electronic device. (101) forms an integral unit with the heat collector device (100).

4. The cooling apparatus for cooling an electronic device (101) as claimed in claim 1, wherein the heat transfer device (300) is made of a thermoplastic polymer.

5. The cooling apparatus for cooling an electronic device (101) as claimed in claim 1, wherein the heat transfer device (300) is made of at least one of polyethylene, polyethylene-terephthalate ahd polystyrene.

6. The cooling apparatus for cooling an electronic device (101) as claimed in claim 1, wherein the heat transfer device (300) includes a metal layer deposited on the outer surface of the heat transfer device (300).

7. The cooling apparatus for cooling an electronic device (101) as claimed in claim 1, wherein the heat transfer device (300) is made of super-elastic alloys.

8. The cooling apparatus for cooling an electronic device (101) as claimed in claim 1, wherein the condenser unit (103) comprises a pump unit (112) for pumping back liquid, which has been collected in a condensate collector (109).

9. The cooling apparatus for cooling an electronic device (101) as claimed in claim 8, wherein the pump unit (112) of the condenser unit (103) is driven by the flow of cooling water (106).

10. The cooling apparatus for cooling an electronic device (101) as claimed in claim 1, wherein the heat collector device (100), the heat sink (200) and the heat transfer device (300) form a thermosyphon device.

11. A method for cooling an electronic device (101) to be cooled, comprising the following steps:
a) collecting heat from the electronic device (101) to be cooled by a heat collector device (100) which is in thermal contact with the electronic device (101) to be cooled;
b) transferring heat which is emitted from the heat collector device (100) to a heat sink (200) by means of a heat transfer device (300) made from a flexible material
c) absorbing heat which is emitted from the heat collector device (100) by means of the heat sink (200) comprising a condenser unit (103) and a thermal interface unit (201), the thermal interface unit (201) being a thermal plug for connecting the condenser unit (103) of the heat sink (200) thermally and removably to an external cooling means; and
d) cooling down the condenser unit (103) via the thermal interface unit (201).

12. The method for cooling an electronic device (101) to be cooled as claimed in claim 11, wherein the heat sink (200) is cooled by a secondary circulation of cooling water (106).

13. The method for cooling an electronic device (101) to be cooled as claimed in claim 11, wherein the heat transfer device (300) transfers heat from the heat collector device (100) to the heat sink (200) by transporting a liquid coolant (104) from the heat collector device (100) to the heat sink (200) and by returning evaporated coolant from the heat sink (200) to the heat collector device (100).

14. The method for cooling an electronic device (101) to be cooled as claimed in claim 12, wherein the condenser unit (103) of the heat sink (200) is directly cooled by the circulating cooling water (106).

## Patentansprüche

1. Kühlungsvorrichtung zum Kühlen einer zu kühlenden elektronischen Vorrichtung (101), die umfasst:
a) eine Wärmesammelvorrichtung (100), die dazu ausgelegt ist, mit der elektronischen Vorrichtung (101) in thermischem Kontakt zu sein;
b) einen Kühlkörper (200), um Wärme, die von der Wärmesammelvorrichtung (100) abgegeben wird, zu absorbieren, die eine Kondensatoreinheit (103) und ein Thermoschnittstelleneinheit (201) enthält, wobei die Kondensatoreinheit (103) über die Thermoschnittstelleneinheit (201) heruntergekühlt wird;
c) eine Wärmeübertragungsvorrichtung (300), die aus einem flexiblen Material hergestellt ist, um Wärme, die von der Wärmesammelvorrichtung (100) abgegeben wird, an den Kühlkörper (200) zu übertragen,
**dadurch gekennzeichnet, dass**
d) die Thermoschnittstelleneinheit (201) als ein thermischer Stopfen entworfen ist, um die Kondensatoreinheit (103) des Kühlkörpers (200) mit einem externen Kühlungsmittel thermisch und lösbar zu verbinden.

2. Kühlungsvorrichtung zum Kühlen einer elektronischen Vorrichtung (101) nach Anspruch 1, wobei die Wärmeübertragungsvorrichtung (300) eine Einheit zur elektrischen Verbindung enthält, um gleichzeitig thermische und elektrische Energie zwischen der elektronischen Vorrichtung (101) und dem Kühlkörper (200) zu übertragen.

3. Kühlungsvorrichtung zum Kühlen einer elektronischen Vorrichtung (101) nach Anspruch 1, wobei die elektronische Vorrichtung (101) mit der Wärmesammelvorrichtung (100) eine integrale Einheit bildet.

4. Kühlungsvorrichtung zum Kühlen einer elektronischen Vorrichtung (101) nach Anspruch 1, wobei die Wärmeübertragungsvorrichtung (300) aus einem thermoplastischen Polymer hergestellt ist.

5. Kühlungsvorrichtung zum Kühlen einer elektronischen Vorrichtung (101) nach Anspruch 1, wobei die Wärmeübertragungsvorrichtung (300) aus Polyethylen und/oder Polyethylen-Terephthalat und/oder Polystyrol hergestellt ist.

6. Kühlungsvorrichtung zum Kühlen einer elektronischen Vorrichtung (101) nach Anspruch 1, wobei die Wärmeübertragungsvorrichtung (300) eine Metallschicht aufweist, die auf der äußeren Oberfläche der Wärmeübertragungsvorrichtung (300) abgelagert ist.

7. Kühlungsvorrichtung zum Kühlen einer elektronischen Vorrichtung (101) nach Anspruch 1, wobei die Wärmeübertragungsvorrichtung (300) aus superelastischen Legierungen hergestellt ist.

8. Kühlungsvorrichtung zum Kühlen einer elektronischen Vorrichtung (101) nach Anspruch 1, wobei die Kondensatoreinheit (103) eine Pumpeinheit (112) umfasst, um Flüssigkeit, die in einem Kondensatsammler (109) gesammelt worden ist, zurückzupumpen.

9. Kühlungsvorrichtung zum Kühlen einer elektronischen Vorrichtung (101) nach Anspruch 8, wobei die Pumpeinheit (112) der Kondensatoreinheit (103) durch die Strömung von Kühlwasser (106) angetrieben wird.

10. Kühlungsvorrichtung zum Kühlen einer elektronischen Vorrichtung (101) nach Anspruch 1, wobei die Wärmesammelvorrichtung (100), der Kühlkörper (200) und die Wärmeübertragungsvorrichtung (300) eine Thermosiphonvorrichtung bilden.

11. Verfahren zum Kühlen einer zu kühlenden elektronischen Vorrichtung (101), das die folgenden Schritte umfasst:
a) Sammeln von Wärme von der zu kühlenden elektronischen Vorrichtung (101) durch eine Wärmesammelvorrichtung (100), die mit der zu kühlenden elektronischen Vorrichtung (101) in thermischem Kontakt ist;
b) Übertragen von Wärme, die von der Wärmesammelvorrichtung (100) abgegeben wird, an einen Kühlkörper (200) mittels einer aus einem flexiblen Material hergestellten Wärmeübertragungsvorrichtung (300);
c) Absorbieren von Wärme, die von der Wärmesammelvorrichtung (100) abgegeben wird, mittels des Kühlkörpers (200), der eine Kondensatoreinheit (103) und eine Thermoschnittstelleneinheit (201) enthält, wobei die Thermoschnittstelleneinheit (201) ein thermischer Stopfen zum thermischen und lösbaren Verbinden der Kondensatoreinheit (103) des Kühlkörpers (200) mit einem externen Kühlungsmittel ist; und
d) Herunterkühlen der Kondensatoreinheit (103) über die Thermoschnittstelleneinheit (201).

12. Verfahren zum Kühlen einer zu kühlenden elektronischen Vorrichtung (101) nach Anspruch 11, wobei der Kühlkörper (200) durch eine sekundäre Zirkulation von Kühlwasser (106) gekühlt wird.

13. Verfahren zum Kühlen einer zu kühlenden elektronischen Vorrichtung (101) nach Anspruch 11, wobei die Wärmeübertragungsvorrichtung (300) Wärme von der Wärmesammelvorrichtung (100) zu dem Kühlkörper (200) durch Transportieren eines flüssigen Kühlmittels (104) von der Wärmesammelvorrichtung (100) zu dem Kühlkörper (200) und durch Zurückleiten von verdampftem Kühlmittel von dem Kühlkörper (200) zu der Wärmesammelvorrichtung (100) überträgt.

14. Verfahren zum Kühlen einer zu kühlenden elektronischen Vorrichtung (101) nach Anspruch 12, wobei die Kondensatoreinheit (103) des Kühlkörpers (200) durch das zirkulierende Kühlwasser (106) direkt gekühlt wird.

## Revendications

1. Appareil de refroidissement destiné à refroidir un dispositif électronique (101) à refroidir, et comprenant :
a) un dispositif (100) de collecte de chaleur adapté pour être en contact thermique avec le dispositif électronique (101),
b) un drain thermique (200) qui absorbe la chaleur émise par le dispositif (100) de collecte de chaleur et qui comprend une unité de condenseur (103) et une unité (201) d'interface thermique, l'unité de condenseur (103) étant refroidie par l'intermédiaire de l'unité (201) d'interface thermique,
c) un dispositif (300) de transfert de chaleur constitué d'un matériau flexible, qui transfère la chaleur émise par le dispositif (100) de collecte de chaleur vers le drain thermique (200),
**caractérisé en ce que**
d) l'unité (201) d'interface thermique est conçue comme bouchon thermique qui relie l'unité de condenseur (103) du drain thermique (200) thermiquement et de manière libérable à un moyen externe de refroidissement.

2. Appareil de refroidissement destiné à refroidir un dispositif électronique (101) selon la revendication 1, dans lequel le dispositif (300) de transfert de chaleur comprend une unité de connexion électrique qui transfère simultanément de l'énergie thermique et de l'énergie électrique entre le dispositif électronique (101) et le drain thermique (200).

3. Appareil de refroidissement destiné à refroidir un dispositif électronique (101) selon la revendication 1, dans lequel le dispositif électronique (101) fait partie intégrante du dispositif (100) de collecte de chaleur.

4. Appareil de refroidissement destiné à refroidir un dispositif électronique (101) selon la revendication 1, dans lequel le dispositif (300) de transfert thermique est constitué d'un polymère thermoplastique.

5. Appareil de refroidissement destiné à refroidir un dispositif électronique (101) selon la revendication 1, dans lequel le dispositif (300) de transfert de chaleur est constitué de polyéthylène, de poly(téréphtalate d'éthylène) et/ou de polystyrène.

6. Appareil de refroidissement destiné à refroidir un dispositif électronique (101) selon la revendication 1, dans lequel le dispositif (300) de transfert de chaleur comprend une couche métallique déposée sur la surface extérieure du dispositif (300) de transfert de chaleur.

7. Appareil de refroidissement destiné à refroidir un dispositif électronique (101) selon la revendication 1, dans lequel le dispositif (300) de transfert de chaleur est constitué d'alliages superélastiques.

8. Appareil de refroidissement destiné à refroidir un dispositif électronique (101) selon la revendication 1, dans lequel l'unité de condenseur (103) comprend une unité de pompage (112) qui pompe en retour le liquide qui a été recueilli dans un collecteur (109) de condensats.

9. Appareil de refroidissement destiné à refroidir un dispositif électronique (101) selon la revendication 8, dans lequel l'unité de pompage (112) de l'unité de condenseur (103) est entraînée par l'écoulement d'eau de refroidissement (106).

10. Appareil de refroidissement destiné à refroidir un dispositif électronique (101) selon la revendication 1, dans lequel le dispositif (100) de collecte de chaleur, le drain thermique (200) et le dispositif (300) de transfert de chaleur forment un dispositif à thermosiphon.

11. Procédé de refroidissement d'un dispositif électronique (101) à refroidir, le procédé comprenant les étapes suivantes :
a) collecter de la chaleur du dispositif électronique (101) à refroidir par un dispositif (100) de collecte de chaleur qui est en contact thermique avec le dispositif électronique (101) à refroidir,
b) transférer la chaleur émise par le dispositif (100) de collecte de chaleur à un drain thermique (200) au moyen d'un dispositif (300) de transfert thermique constitué d'un matériau flexible,
c) absorber la chaleur émise par le dispositif (100) de collecte de chaleur au moyen du drain thermique (200) qui comprend une unité de condenseur (103) et une unité (201) d'interface thermique, l'unité (201) d'interface thermique étant un bouchon thermique qui relie l'unité de condenseur (103) du drain thermique (200) thermiquement et de manière libérable à un moyen externe de refroidissement et
d) refroidir l'unité de condenseur (103) par l'intermédiaire de l'unité (201) d'interface thermique.

12. Procédé de refroidissement d'un dispositif électronique (101) à refroidir selon la revendication 11, dans lequel le drain thermique (200) est refroidi par une circulation secondaire d'eau de refroidissement (106).

13. Procédé de refroidissement d'un dispositif électronique (101) à refroidir selon la revendication 11, dans lequel le dispositif (300) de transfert de chaleur transfère de la chaleur du dispositif (100) de collecte de chaleur au drain thermique (200) en transportant un liquide de refroidissement (104) depuis le dispositif (100) de collecte de chaleur jusqu'au drain thermique (200) et en renvoyant l'agent de refroidissement évaporé du drain thermique (200) vers le dispositif (100) de collecte de chaleur.

14. Procédé de refroidissement d'un dispositif électronique (1 01) à refroidir selon la revendication 12, dans lequel l'unité de condenseur (103) du drain thermique (200) est refroidie directement par l'eau de refroidissement (106) en circulation.
